# EUROPEAN PATENT SPECIFICATION

(11) **EP 1 237 178 B1**
(45) Date of publication and mention of the grant of the patent: **07.01.2009**
(21) Application number: 01105179.4
(22) Date of filing: 02.03.2001
(51) Int. Cl.: H01L 21/00

(54) **Self-supporting adaptable metrology device**
Selbsttragendes und anpassbares Messgerät
Dispositif de métrologie adaptable et autoportant

(43) Date of publication of application: 04.09.2002
(73) Proprietor: Qimonda Dresden GmbH & Co. oHG, 01099 Dresden (DE); ICOS VISION SYSTEMS N.V., 3001 Heverlee (BE)
(72) Inventor: Marx, Eckhard, 01471 Radeburg (DE); Gerhard, Detlef, 81739 München (DE); Tegeder, Volker, 01474 Weissig (DE); Lechner, Johannes, 80798 München (DE)
(74) Representative: Epping - Hermann - Fischer

(56) References cited:
- EP-A- 0 377 464
- US-A- 4 715 921
- US-A- 4 852 516
- US-A- 6 053 687

## Description

The invention refers to a metrology device to be coupled to a semiconductor product handling and/or processing tool enclosing a mini-environmental atmosphere, the metrology device comprising a housing preserving an inner atmosphere, a coupling region for connecting the inner atmosphere to the mini-environmental atmosphere and measuring means for measuring a property of a semiconductor product.

In the manufacture of semiconductor products, several process steps are performed by process tools which are, for instance, combined to cluster tools including one wafer handling tool. Within the cluster tools the semiconductor products are handled and processed within a mini-environment which is a cleanroom atmosphere of higher purity than the cleanroom atmosphere accommodating operating personnel and the cluster tools. Due to the complexity of modern semiconductor product processing often requiring several hundreds of processing steps, intermediate control of processing results and physical, chemical, or other properties of the semiconductor products is necessary. Often the necessity of controlling such a property arises during semiconductor product processing. In any case, measurements have to be performed during or interrupting, respectively, a rather complex process routine.

With view to the costs of running processing tools, it would be desirable to minimize the time of interruption caused by these measurements. However, due to the mini-environmental cleanroom requirements, the semiconductor products must not get into contact with the outer atmosphere surrounding the processing tools.

In order to preserve the mini-environmental atmosphere, wafers are intermediately stored in so-called FOUPs (front-opening unified pods) docked at a loadport, that is a device for loading or unloading FOUPs. Usually, loadports are allocated at front-end process modules for wafer handling and loading and unloading process tools.

The FOUP containing a semiconductor product also preserves the mini-environmental atmosphere around it and hence allows for air-tight transport of the semiconductor product within the outer cleanroom atmosphere of minor purity. The semiconductor product in the FOUP is transported to a second loadport connected to a measuring tool, unloaded, subjected to the measurement, reloaded and transported to the loadport connected to the cluster tool in order to continue semiconductor processing.

Due to this proceeding, semiconductor products to be measured have to be transported twice. In order to save time and efforts for transport, it would be possible to permanently combine the measurement device with the cluster tool. In this case, FOUP transport would not be required. However, this is not realized up to now because of several reasons:
First, measurement devices are supplied by various engineering companies. Each measurement device of any one of these companies would require high efforts for integration into and interaction with highly automated cluster tools. It is not profitable to spend time and costs for extending the cluster each time when any measurement device of one of the various suppliers is integrated.
Second, such integration efforts would arise already in advance already before testing the compatibility of a measurement device and a cluster tool. As the compatibility has to be proven before selecting a measurement device of a particular supplier, the integration costs would add up to the costs of the devices chosen or, with respect to those devices not bought from the other suppliers, would be spent to no purpose.
Finally, present FOUPs and loadports are standardized and therefore offer simple connection to stand-alone measuring devices.

For these reasons, wafers to be subjected to a measurement are transported to and from the loadport connected to such measurement device.

The European Patent Application EP 1139390, published on 04.10.01 is not relevant under A54(3) EPC the metrology device is not self supporting in a position appropriate for quick coupling of the coupling region to the tool. It discloses a device as described in the first paragraph above. A FOUP ordinarily employed for exclusively transporting wafers comprises a sensor for measuring a property of a wafer allocated in the FOUP. As the housing of the FOUP preserves the mini-environment and the FOUP is easily coupled by its coupling region to the cluster tool, the measurement can be performed directly at the loadport; the need of transport no longer arises.

Further devices are disclosed in EP 3 77464 and EP 4715921.

The loadports themselves, however, must maintain mini-environmental atmospheric conditions when a FOUP is docked thereto. In no case any leakage between the FOUP and the loadport may be tolerated. Therefore, a special seal is located between the loadport and the FOUP and surrounds a passage for transferring a wafer between the loadport and the FOUP.

Effective passage sealing as well as wafer handling require exact positioning of the FOUP relative to the loadport. To this end, a loadport comprises a table with three pins supporting the FOUP when it is docked to the sealing of the loadport. Exact positioning of the FOUP is granted by the suppliers of the loadport only to a certain maximum weight of the FOUP. In 300 mm production, this maximum weight amounts about 12 kg and approximately corresponds to the weight of a FOUP loaded with the maximum number of wafers allowed.

When a metrology device is integrated in a FOUP, this maximum weight must not be exceeded because otherwise exact positioning could not be granted so that a leakage of the sealing might accur. As a consequence, only lightweight metrology devices as sensors requiring few hardware and software equipment can be integrated into a FOUP.

It is the object of the present invention as claimed in claim 1 to provide a metrology device which, regardless of its dimensions or weight, can rapidly be coupled to a semiconductor product handling and/or processing tool with very little effort and which grants for comparable leakage prevention during coupling and decoupling as the lightweight FOUP does.

According to the invention, this object is achieved by a metrology device constructed comprising a support which is movable on a ground by transport means and which is dimensioned such that the metrology device is self-supporting in a position appropriate for quick coupling of the coupling region to the tool.

The general idea underlying the invention is, proceeding from the above-mentioned loadport FOUP support, to position the metrology device independently and separately from any maximum weight depending support members of the cluster tool. Whereas according to prior art both mechanical positioning and atmospheric connection or isolation, respectively, are achieved by the loadport forming part of the cluster tool, according to the invention merely the atmospheric connection is primarily achieved by the cluster tool whereas mechanical positioning and support are achieved by the metrology device itself regardless of positioning members eventually existing at each present cluster tool.

Preferably, the self-supporting metrology device is constructed such that the coupling region is located in a height appropriate for coupling to the tool. As a consequence, quick coupling of the metrology device to the tool without the need of lifting weighty compartments (like FOUPs, according to prior art) is achieved.

According to a preferred embodiment, the support forms part of the housing preserving the inner atmosphere. Accordingly, complete volume of the metrology device can be coupled to mini-environmental atmosphere. This saves coupling stations as according to this embodiment several semiconductor products can be measured or various measurements can be performed within one single mini-environmental metrology device. Hence, preferably also the support is constructed to accommodate measuring means.

Preferably, the support comprises means for adapting the position of the metrology device to different sizes of tools. Thereby any particular metrology device can be coupled to cluster tool coupling regions of different standard sizes.

According to a preferred embodiment of the invention, the metrology device is constructed to receive a semiconductor product through an opening of the coupling region in order to perform the measurement inside the housing. As a consequence, the handling tool of the frontend process module of a cluster tool can be utilized for other handling operations during measurement. Furthermore, performing the measurement in the housing of the metrology device allows for nearest contact of measuring equipment to the semiconductor surface from all directions. However, alternatively, the metrology device may interact with the cluster tool, for instance by means of measurement sensors protruding into an opening of the cluster tool, for performing the measurement.

The transport means of the support preferably form part of the support. Preferably, they are rollers.

According to another preferred embodiment of the invention, the support comprises a docking region mechanically dockable to the tool. This construction may be developed to form further advantageous embodiments:
First, the docking region may comprise members for fixing a position of the metrology device relative to the tool. These members may be mechanically lockable pins. Preferably, both the coupling region usually located above as well as the docking region of the support located beneath are equipped with locking members so that stability of the metrology device coupled to the cluster tool is increased in case of uneven ground. However, the coupling region primarily serves to atmospherically couple the metrology device and the cluster tool and isolate them from the surrounding cleanroom atmosphere of minor purity.
Second, the docking region preferably may comprise a conduct region coupleable to the tool. The conduct region serves to supply all media and other sources which are required for driving the metrology device. Thereby a plug-and-play performance of the complete metrology device is granted. Preferably, the conduct region supplies data transfer, power, pressured gas or other media from the tool to the metrology device. Furthermore, the conduct region may comprise exhaust lines for exhaust transport of gases from the metrology device to the tool.

With view to the function of the coupling region of connecting the inner atmosphere to the mini-environmental atmosphere, the coupling region preferably comprises a respective sealing. However, the cluster tool may have a sealing instead. Preferably, both the cluster tool and the metrology device comprise a respective sealing interacting with one another in order to more safely prevent any leakage of mini-environmental atmosphere.

The coupling region and/or the support comprise elements for vibration damping. Furthermore, the metrology device may comprise a table for vibration damping, the table preferably consisting of granite or another kind of stone and designed to have a great mass.

The metrology device is coupleable to a loadport, its support preferably having a recess for accommodating a loadport table.

According to these embodiments, a loadport is occupied by coupling a metrology device according to the invention instead of an ordinary FOUP. Hence, any loadport may be utilised as a docking station for measurement equipment of any weight and size.

The upper portion of the metrology device is supported in a position preventing contact to contact members of the loadport table. Standardised loadport tables comprise three pins allocated for FOUP support up to the maximum weight allowed. These contact pins are no longer necessary as according to the invention the metrology device is self-supporting. A gap of at least several millimetres is recommendable between the upper side of the loadport table and that portion of the metrology device extending above the loadport table in order to prevent unintentional damage of the FOUP support pins when coupling the metrology device to the loadport.

Preferably, the support comprises means for adapting the position of the metrology device to different loadport sizes. Though loadports are standardized, there are different standard dimensions preventing unique coupling of one single housing lacking any size adaptation facilities. Preferably, the height of the coupling region of the metrology device extending above the loadport table may be variable.

According to advanced preferred embodiments of the invention, the metrology device is designed as a cluster device. Preferably, it is a cluster device comprising measuring means for measuring at least two properties of a semiconductor product. Alternatively or in addition, the metrology device is a cluster tool comprising measuring means for measuring properties of at least two semiconductor products.

Hereinbelow, the invention is described with reference to the accompanying figures. The figures illustrate:
Figure 1 a perspective view of a front side wall of a cluster tool, the front side comprising three loadports A, B, C, loadport A being occupied by a metrology device according to the present invention and loadport C being occupied according to prior art by a standardised FOUP to be loaded with wafers and destined for manual transport of the wafers to another loadport connected to a prior art stand-alone measuring tool not shown,
Figures 2A and 2B a perspective view of the backside of a metrology device according to the invention and a loadport connected to this metrology device as well as a side view of the metrology device and the loadport connected to each other,
Figure 2C a cross-sectional view of Figure 2B,
Figure 3 a perspective view of the front side wall of a cluster tool comprising two loadports and a third docking station other than a loadport, this docking station being occupied by a metrology device according to a second embodiment of the invention,
Figures 4A and 4B perspective views of the backside of the metrology device according to the other embodiment of the invention and of a cluster tool wall connected to such a metrology device,
Figure 5 a perspective view of the other embodiment of the invention.

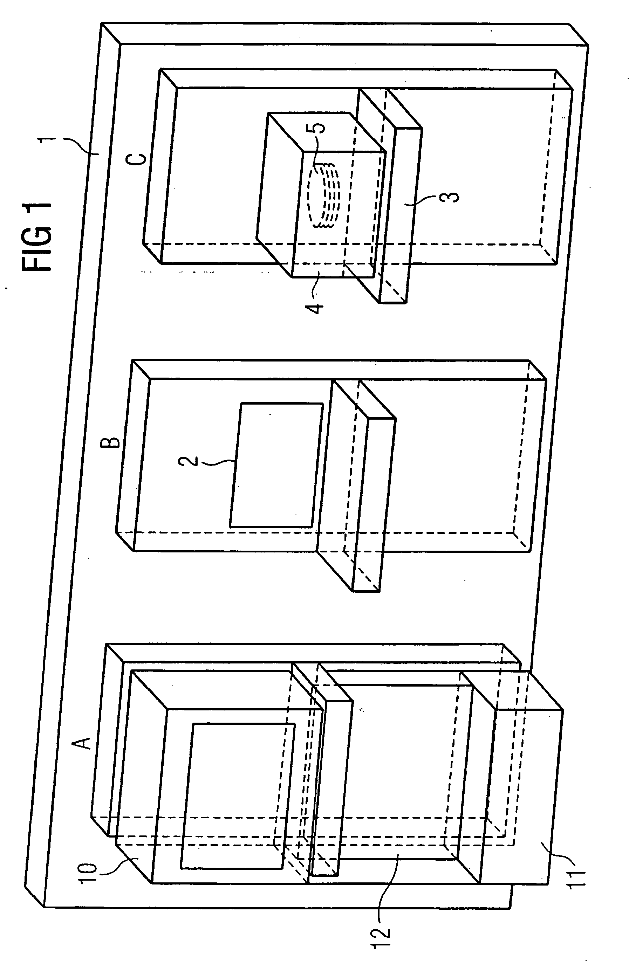

According to Figure 1, the front side wall 1 of a cluster tool comprises three loadports A, B, C. Loadport B is not occupied; its opening 2 is closed in order to prevent any leakage of the mini-environmental atmosphere behind.

Loadport C is occupied according to prior art with a FOUP 4 schematically illustrated and being supported by the loadport table 3.

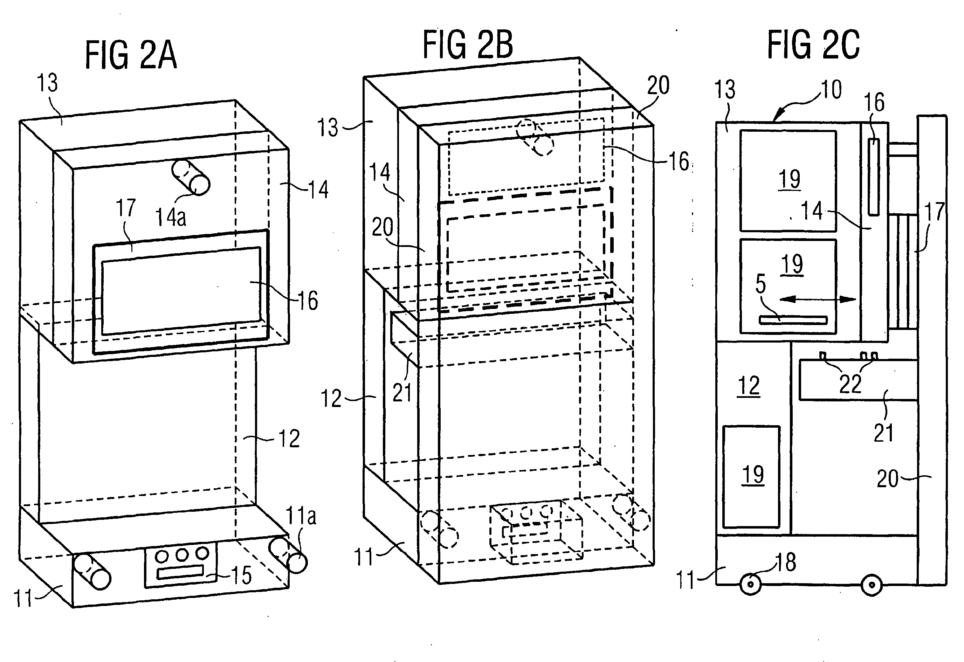

Loadport A is occupied by a metrology device 10 according to the present invention. The metrology device is constructed comprising a support 11, 12 illustrated in detail in Figure 2A.

Figures 2A and 2B illustrate details of the metrology device according to the invention in perspective view from behind. An upper portion 13 of the metrology device comprises a coupling region 14 to be coupled to the cluster tool. The support of the metrology device comprises a docking region 11 to be docked simultaneously with the coupling region 14 to the cluster tool. The support further comprises a height adaptation module 12 dimensioned such that the metrology device is self-supporting in a position appropriate for quick coupling of the coupling region 14 to the cluster tool. The housing preserving an inner atmosphere which is the mini-environmental atmosphere when connected to the cluster tool may comprise the upper portion 13 only or the complete housing of the metrology device including the support 11, 12. In any case, the support 11 comprises a conduct region 15 coupleable to the tool for supplying data transfer, power, pressure, gas, or other media from the cluster tool to the metrology device or for supporting exhaust gases from the metrology device to the cluster tool. Conduct lines not illustrated in Figure 2A extend from the coupling region 15 through the support 11, 12 to the upper portion 13 or to any region within the support 11, 12 forming part of the inner atmosphere surrounded by the housing 13 (,12, 11). Data transfer or power, however, may be supplied also to a region external of the housing enclosing the inner atmosphere as in case of computing devices not necessarily allocated within a mini-environmental atmosphere.

The coupling region 14 and the docking region 11 comprise members 14a, 11a for fixing a position of the metrology device relative to the tool. Preferably, these members are lockable pins intruding to corresponding recesses in front of the loadport illustrated in Figure 2B. The loadport 20 comprises a loadport table 21 extending into the footprint occupied by the metrology device 11, 12, 13. For this reason, the support region 12 has less extension in direction perpendicular to the drawing plane than the support region 11 and the upper device portion 13. Hence, the support region 12 forms a recess for accommodating the loadport table 21.

As there are different standardized loadports and, as a consequence, different possible heights of loadport tables 21, the recess between the regions 13 and 11 extends far below the loadport table 21 illustrated in Figure 2C. The coupling region 14 is constructed to comprise a door 16 closing an opening surrounded by a sealing 17. The door 16 may be removed from the opening when the metrology device 11, 12, 13 is coupled to the loadport 20 of the cluster tool as illustrated in Figures 2B, 2C.

Figure 2C illustrates the metrology device 10 docked to the loadport 20 in cross-sectional view. The support 11 is movable on a ground not illustrated by transport means which in simplest case may be rollers 18. The upper portion 13 of the metrology device 10 as well as its support 11, 12 accommodate measuring means 19 for measuring a property of a semiconductor product. Compared to the FOUP 4 docked at loadport C in Figure 1 and schematically drawn larger than in reality, the metrology device 10 according to the invention as illustrated in Figure 2C may accommodate and couple metrology means 19 of unlimited size and weight to the loadport 20 of a cluster tool. Whereas the loadport 20 is destined for coupling a FOUP for wafer loading and unloading for the purpose of transport and, as a consequence, the pins 22 in Figure 2C only serve as FOUP support members according to prior art, they are not employed when coupling the metrology device 10 according to the present invention to the loadport 20. For this reason, the upper portion 13 of the metrology device is supported in a position preventing contact to these contact members 22 of the loadport table 21. The metrology device illustrated in Figure 2C may comprise several measuring means 19 for measuring properties of several semiconductor products and/or for measuring several properties of one or more semiconductor products 5. Hence, a cluster metrology device directly coupled to a cluster tool eliminates the need of manual transport of wafers 5 in FOUPs. Hence, intermediate measurement between two process steps at the same cluster tool does not delay subsequent process steps.

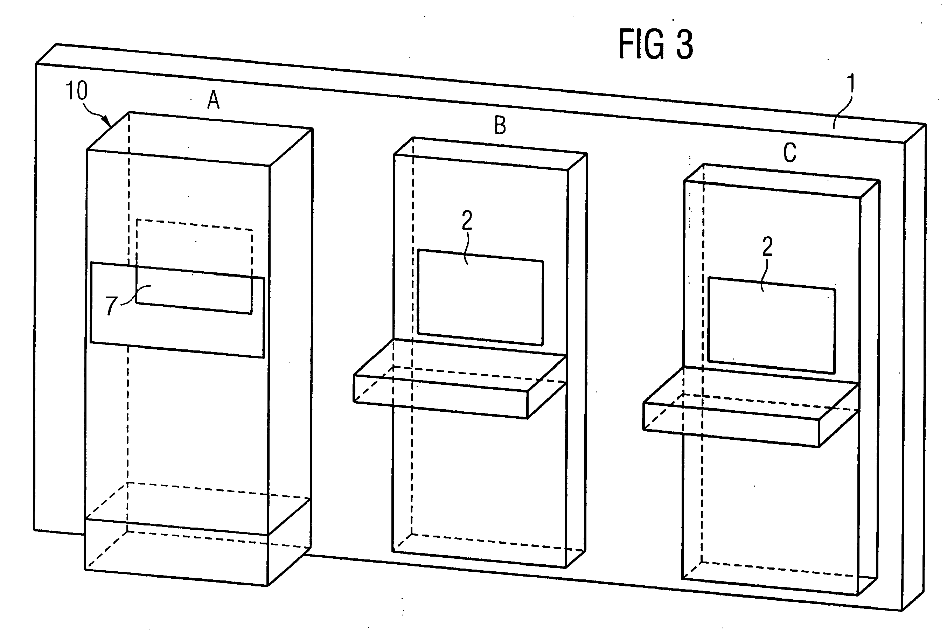

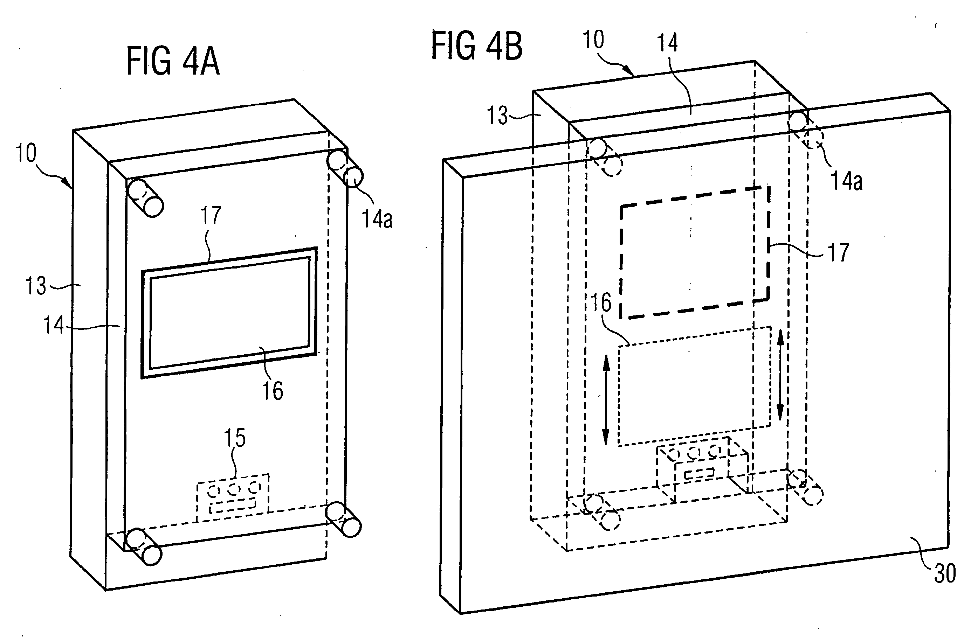

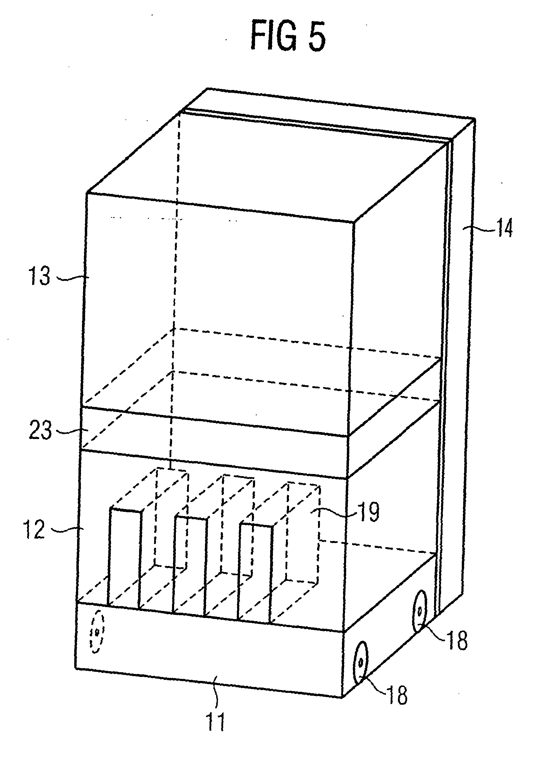

Figures 3 to 5 illustrate another embodiment of the invention. Figure 5 illustrates a metrology device coupleable to a front-end process module illustrated in Figure 3. The frontend process module in Figure 3 comprises two loadports B and C which are not occupied. In region A of the frontend process module 1, the metrology device 10 according to the second embodiment of the invention is coupled with the frontend process module. Details of the front of the process module 1 and of the backside of the metrology device 10 are not visible in Figure 5 as they are illustrated in Figure 4 showing the metrology device in perspective view from behind. However, the coupling region A comprises a closeable opening similar to those openings 2 of the loadports B and C.

Figures 4A and 4B illustrate the coupling region 14 of the housing 13 preserving the inner atmosphere of the metrology device 10. In Figure 4B, the coupling region 14 is coupled to the wall 30 of the process module. The front-end process module usually serves for wafer handling, prealignment, and wafer identification and is located at the front of the cluster tool. The front side of the front-end process module usually comprises loadports. The metrology device may be coupled to a front side wall at a location A not comprising a loadport as illustrated in Figure 3. However, alternatively, the wall 30 in Figure 4B can also be a right-hand or left-hand side wall of a frontend process module. As apparent from Figure 3, the wall 30 comprises a closeable opening 7. However, it is not possible to couple a FOUP to this opening as there is no support like a loadport table at this wall 30. Instead, the opening 7 is coupled with the coupling region 14 illustrated in Figure 4A such that the opening 7 of the cluster tool and the opening 16 of the metrology device 10 are located in opposition to each other. The sealing 17 surrounds the passage between both openings and thereby allows for coupling of the mini-environmental atmosphere of the cluster tool and the inner atmosphere of the metrology device by isolating the passage between these openings from the atmosphere surrounding both the metrology device and the cluster tool when these are combined with each other as illustrated in Figure 4B. The coupling region 14 of the metrology device 13 comprises four lockable pins 14a protruding into the wall 30 of the cluster tool in Figure 4B. However, the metrology device is self-supporting so that the pins 14a do not carry the metrology device.

Figure 5 illustrates the metrology device in front-side perspective view. It is supported by rollers 18 and comprising the housing 13 enclosing a mini-environmental atmosphere in an upper part of the metrology device supported by the table 23 for vibration damping. Beneath this table, the support 11, 12 accommodates additional measuring means 19 not necessarily enclosed by mini-environmental atmosphere. However, there may be conduct lines in the support 11, 12 supplying the housing 13 with media from the media connector block 15 shown in Figure 4A from the cluster tool. As the rear panel 14 may cover the whole back wall of the metrology device, the position of the docking region 15 in Figure 4A is only exemplary.

According to the present invention, any measuring means may be coupled to a cluster tool. Furthermore, means for wafer transfer, xy-rotation wafer stages, wafer identification, and sensor movement may be integrated in the metrology module. Measuring means preferably accommodated in the support of the metrology device are standard frames, electronics, personal computers, etc. The support may comprise a transport module 11 with rollers or adjustable feet with vibration dampers as transport means 18.

## Claims

1. Metrology device (10) couplable to a loadport (20, 21) of a semiconductor product handling and/or processing tool (1) enclosing a mini-environmental atmosphere, the metrology device comprising
- a housing (13) preserving an inner atmosphere,
- a coupling region (14) suitable for connecting the inner atmosphere to the mini-environmental atmosphere and
- measuring means (19) suitable for measuring a property of a semiconductor product,
wherein
- the metrology device is constructed comprising a support (11, 12) which is movable on a ground by transport means (18) and which is dimensioned such that the metrology device is self-supporting in a position appropriate for quick coupling of the coupling region (14) to the tool (1),
- the support (11, 12) of the metrology device (10) has a recess suitable for accomodating a loadport table (21) of the loadport (20, 21) and
- an upper portion (13) of the metrology device (10) is supported in a position preventing contact to contact members (22) of the loadport table (21).

2. Metrology device according to claim 1
**characterized in that**
the self-supporting metrology device is constructed such that the coupling region (14) is located in a height appropriate for coupling to the tool (1).

3. Metrology device according to one of claims 1 or 2,
**characterized in that**
the support forms part of the housing (11, 12, 13) preserving the inner atmosphere.

4. Metrology device according to one of claims 1 to 3,
**characterized in that**
the support (12) is constructed to accomodate measuring means (19).

5. Metrology device according to one of claims 1 to 4,
**characterized in that**
the supporting comprises means (11) for adapting the position of the metrology device (13) to different sizes of tools (1, 20).

6. Metrology device according to one of claims 1 to 5,
**characterized in that**
the metrology device (10) is constructed to receive a semiconductor product (5) through an opening (16) of the coupling region (14) in order to perform the measurement inside the housing (13).

7. Metrology device according to one of claims 1 to 6,
**characterized in that**
the transport means (18) of the support are rollers (18).

8. Metrology device according to one of claims 1 to 7,
**characterized in that**
the support comprises a docking region (15) mechanically dockable to the tool (1).

9. Metrology device according to claim 8,
**characterized in that**
the coupling region (14) and/or the docking region (11) comprise members (16) for fixing a position of the metrology device relative to the tool.

10. Metrology device according to one of claims 8 or 9,
**characterized in that**
the docking region (11) comprises a conduct region (15) coupleable to the tool (1), the conduct region (15) being suitable for supplying data transfer, power, pressured gas or other media from the tool (1) to the metrology device (10).

11. Metrology device according to one of claims 1 to 10,
**characterized in that**
the coupling region (14) comprises a sealing (17) surrounding an opening.

12. Metrology device according to one of claims 1 to 11,
**characterized in that**
the coupling region and/or the support comprise elements (11, 14) for vibration damping.

13. Metrology device according to one of claims 1 to 12,
**characterized in that**
the metrology device comprises a table (23) for vibration damping.

14. Metrology device according to one of claims 1 to 13,
**characterized in that**
the support (11, 12) comprises means (11) for adapting the position of the metrology device (10) to different loadport sizes.

15. Metrology device according to one of claims 1 to 14,
**characterized in that**
the metrology device is a cluster device comprising measuring means (19) suitable for measuring at least two properties of a semiconductor product.

16. Metrology device according to one of claims 1 to 15,
**characterized in that**
the metrology device is a cluster device comprising measuring means (19) suitable for measuring properties of at least two semiconductor products.

## Patentansprüche

1. Messeinrichtung (10), die an eine Ladeschleuse (20, 21) einer Handhabungs- und/oder Bearbeitungsanlage (1) für Halbleiterprodukte, die eine interne Umgebungs-Atmosphäre einschließt, ankoppelbar ist, wobei die Messeinrichtung umfasst:
- ein Gehäuse (13), das eine innere Atmosphäre aufrechterhält,
- einen Ankopplungsbereich (14), der geeignet ist, die innere Atmosphäre mit der internen Umgebungs-Atmosphäre zu verbinden, und
- Messmittel (19), die geeignet sind, eine Eigenschaft eines Halbleiterprodukts zu messen,
wobei
- die Messeinrichtung derart konstruiert ist, dass sie einen Träger (11, 12) aufweist, der durch Transportmittel (18) auf einem Boden bewegbar ist und so dimensioniert ist, dass die Messeinrichtung sich selbst in einer Position trägt, die zum schnellen Ankoppeln des Ankopplungsbereichs (14) an die Anlage (1) geeignet ist,
- der Träger (11, 12) der Messeinrichtung (10) eine Aussparung besitzt, die geeignet ist, einen Ladeschleusentisch (21) der Ladeschleuse (20, 21) aufzunehmen, und
- ein oberer Teil (13) der Messeinrichtung (10) in einer Position getragen wird, die einen Kontakt mit Kontaktgliedern (22) des Ladeschleusentisches (21) verhindert.

2. Messeinrichtung nach Anspruch 1,
**dadurch gekennzeichnet, dass**
die sich selbst tragende Messeinrichtung so konstruiert ist, dass sich der Ankopplungsbereich (14) in einer zum Ankoppeln an die Anlage (1) geeigneten Höhe befindet.

3. Messeinrichtung nach einem der Ansprüche 1 oder 2,
**dadurch gekennzeichnet, dass**
der Träger einen Teil des Gehäuses (11, 12, 13), das die innere Atmosphäre aufrechterhält, bildet.

4. Messeinrichtung nach einem der Ansprüche 1 bis 3,
**dadurch gekennzeichnet, dass**
der Träger (12) so konstruiert ist, dass er Messmittel (19) aufnehmen kann.

5. Messeinrichtung nach einem der Ansprüche 1 bis 4,
**dadurch gekennzeichnet, dass**
der Träger Mittel (11) zum Anpassen der Position der Messeinrichtung (13) an unterschiedliche Größen von Anlagen (1, 20) aufweist.

6. Messeinrichtung nach einem der Ansprüche 1 bis 5,
**dadurch gekennzeichnet, dass**
die Messeinrichtung (10) so konstruiert ist, dass sie, um die Messung innerhalb des Gehäuses (13) durchzuführen, durch eine Öffnung (16) des Ankopplungsbereichs (14) ein Halbleiterprodukt (5) aufnimmt.

7. Messeinrichtung nach einem der Ansprüche 1 bis 6,
**dadurch gekennzeichnet, dass**
die Transportmittel (18) des Trägers Rollen (18) sind.

8. Messeinrichtung nach einem der Ansprüche 1 bis 7,
**dadurch gekennzeichnet, dass**
der Träger einen Andockbereich (15) aufweist, der mechanisch an die Anlage (1) andockbar ist.

9. Messeinrichtung nach einem der Ansprüche 1 bis 7,
**dadurch gekennzeichnet, dass** der Ankopplungsbereich (14) und/oder der Andockbereich (15) Glieder (16) zum Fixieren einer Position der Messeinrichtung relativ zur Anlage umfassen.

10. Messeinrichtung nach einem der Ansprüche 8 oder 9,
**dadurch gekennzeichnet, dass**
der Andockbereich (15) einen Leitungsbereich (15) umfasst, der an die Anlage (1) ankoppelbar ist, wobei der Leitungsbereich (15) geeignet ist, um Daten, Strom, unter Druck stehendes Gas oder andere Medien von der Anlage (1) zur Messeinrichtung (10) zu befördern.

11. Messeinrichtung nach einem der Ansprüche 1 bis 10,
**dadurch gekennzeichnet, dass**
der Ankopplungsbereich (14) eine Dichtung (17) umfasst, die eine Öffnung umgibt.

12. Messeinrichtung nach einem der Ansprüche 1 bis 11,
**dadurch gekennzeichnet, dass**
der Ankopplungsbereich und/oder der Träger Elemente (11, 14) zur Schwingungsdämpfung umfassen.

13. Messeinrichtung nach einem der Ansprüche 1 bis 12,
**dadurch gekennzeichnet, dass**
die Messeinrichtung einen Tisch (23) zur Schwingungsdämpfung umfasst.

14. Messeinrichtung nach einem der Ansprüche 1 bis 13,
**dadurch gekennzeichnet, dass**
der Träger (11, 12) Mittel (11) zum Anpassen der Position der Messeinrichtung (10) an unterschiedliche Größen von Ladeschleusen umfasst.

15. Messeinrichtung nach einem der Ansprüche 1 bis 14,
**dadurch gekennzeichnet, dass**
die Messeinrichtung eine Cluster-Einrichtung ist, die Messmittel (19) umfasst, die geeignet sind, mindestens zwei Eigenschaften eines Halbleiterprodukts zu messen.

16. Messeinrichtung nach einem der Ansprüche 1 bis 15,
**dadurch gekennzeichnet, dass**
die Messeinrichtung eine Cluster-Einrichtung ist, die Messmittel (19) umfasst, die geeignet sind, Eigenschaften von mindestens zwei Halbleiterprodukten zu messen.

## Revendications

1. Instrument métrologique (10) couplable à un port de chargement (20, 21) d'un outil de manipulation ou de traitement (1) d'un produit semi-conducteur et comportant une atmosphère mini-environnementale, l'instrument métrologique comprenant
- un boîtier (13) préservant l'atmosphère interne,
- une zone de couplage (14) adaptée pour connecter l'atmosphère interne à l'atmosphère mini-environnementale, et
- un moyen de mesure (19) adapté pour mesurer une propriété d'un produit semi-conducteur,
dans lequel
- l'instrument métrologique comprend un support (11, 12) déplaçable sur une surface grâce à un moyen de transport (18) et dimensionné de telle sorte que l'instrument métrologique est autoportant dans une position adaptée à un accouplement rapide de la zone de couplage (14) à l'outil (1),
- le support (11, 12) de l'instrument métrologique (10) comporte un logement adapté pour recevoir une plaque de port de chargement (21) du port de chargement (20, 21) et
- une partie supérieure (13) de l'instrument métrologique (10) est supportée dans une position évitant un contact avec des pièces de contact (22) de la plaque du port de chargement (21).

2. Instrument métrologique selon la revendication 1,
**caractérisé en ce que**
l'instrument métrologique autoportant est constitué de telle sorte que la zone de couplage (14) est située à une hauteur adaptée pour l'accouplement à l'outil (1).

3. Instrument métrologique selon l'une des revendications 1 ou 2,
**caractérisé en ce que**
le support forme partie du boîtier (11, 12, 13) préservant l'atmosphère interne.

4. Instrument métrologique selon l'une des revendications 1 à 3,
**caractérisé en ce que**
le support (12) est conçu pour recevoir un moyen de mesure (19).

5. Instrument métrologique selon l'une des revendications 1 à 4,
**caractérisé en ce que**
le support comporte un moyen (11) d'adaptation de la position de l'instrument métrologique (13) à différentes tailles d'outil (1, 20).

6. Instrument métrologique selon l'une des revendications 1 à 5,
**caractérisé en ce que**
l'instrument métrologique (10) est conçu pour recevoir un produit semi-conducteur (5) à travers une ouverture (16) de la zone de couplage (14) pour effectuer la mesure à l'intérieur du boîtier (13).

7. Instrument métrologique selon l'une des revendications 1 à 6,
**caractérisé en ce que**
le moyen de transport (18) du support consiste en des galets (18).

8. Instrument métrologique selon l'une des revendications 1 à 7,
**caractérisé en ce que**
le support comporte une zone d'arrimage (15) mécaniquement arrimable à l'outil (1).

9. Instrument métrologique selon la revendication 8,
**caractérisé en ce que**
la zone de couplage (14) ou la zone d'arrimage (11) comporte des pièces (16) permettant d'immobiliser l'instrument métrologique dans une position déterminée par rapport à l'outil.

10. Instrument métrologique selon l'une des revendications 8 ou 9,
**caractérisé en ce que**
la zone d'arrimage (11) comporte une zone de conduction (15) couplable à l'outil (1), la zone de conduction (15) étant adaptée pour assurer l'alimentation en données, en puissance, en gaz pressurisé ou en d'autres flux de l'outil (1) vers l'instrument métrologique (10).

11. Instrument métrologique selon l'une des revendications 1 à 10,
**caractérisé en ce que**
la zone de couplage (14) comporte une étanchéité (17) autour de l'ouverture.

12. Instrument métrologique selon l'une des revendications 1 à 11,
**caractérisé en ce que**
la zone de couplage ou le support comporte des éléments (11, 14) d'amortissement des vibrations.

13. Instrument métrologique selon l'une des revendications 1 à 12,
**caractérisé en ce que**
l'instrument métrologique comporte une plaque (23) d'amortissement des vibrations.

14. Instrument métrologique selon l'une des revendications 1 à 13,
**caractérisé en ce que**
le support (11, 12) comporte un moyen (11) d'adaptation de la position de l'instrument métrologique (10) à différentes tailles de port de chargement.

15. Instrument métrologique selon l'une des revendications 1 à 14,
**caractérisé en ce que**
l'instrument métrologique est un appareil à barillet comportant un moyen de mesure (19) adapté pour mesurer au moins deux propriétés d'un produit semi-conducteur.

16. Instrument métrologique selon l'une des revendications 1 à 15,
**caractérisé en ce que**
l'instrument métrologique est un appareil à barillet comportant un moyen de mesure (19) adapté pour mesurer les propriétés d'au moins deux produits semi-conducteurs.
